# DEMANDE DE BREVET EUROPEEN

(11) **EP 0 707 215 A2**
(43) Date de publication de la demande: **17.04.1996**
(21) Numéro de dépôt: 95402281.0
(22) Date de dépôt: 13.10.1995
(51) Int. Cl.: G01R 19/25

(54) **Dispositif de transmission séparée de données et d'énergie pour un appareil de mesure**

(30) Priorité: 13.10.1994 DE 4436592
(71) Demandeur: GENERAL ELECTRONIK GMbH bei MAGDEBURG, D-39167 Hohendodeleben bei Magdeburg (DE)
(72) Inventeur: Bangerter, Michael, D-90411 Nürnberg (DE)
(74) Mandataire: Kohn, Philippe

(57) **Abrégé**

L'invention concerne un dispositif de transmission séparée de données et d'énergie pour appareil de mesure portatif, tel qu'un multimètre à pince ampèremétrique, caractérisé en ce que la transmission de données s'effectue par l'intermédiaire de condensateurs de couplage qui sont constitués, chacun, de deux surfaces conductrices (C1, C1'; C2, C2') implantées sur des faces opposées l'une à l'autre de deux feuilles supports (10, 20), en ce que la transmission d'énergie s'effectue par l'intermédiaire d'un transformateur qui est constitué de deux moitiés de noyau (Ü1, Ü2) fixées sur des faces opposées l'une à l'autre des feuilles supports (10, 20) et comportant des enroulements primaires et secondaires (L1 à L4), en ce qu'au moins une des feuilles supports (10, 20) est une feuille isolante résistant aux hautes tensions, et en ce que les deux feuilles sont collées l'une sur l'autre.

## Description

La présente invention concerne les appareils de mesure portatifs et, plus particulièrement un dispositif destiné à la transmission de données et d'énergie avec séparation galvanique pour un tel appareil de mesure.

Avec tels appareils de mesure portatifs qui sont alimentés par des piles ou des batteries, on effectue des mesures, par exemple de courant et de tension, sur les conducteurs d'installations à moyenne et haute tension. Dans le cas d'un appareil à pince ampèremétrique (pince de courant), la mesure est réalisée en ouvrant la pince et en la plaçant autour du conducteur et la tension des conducteurs concernés est appliquée à l'appareil par l'intermédiaire de douilles disposées dans l'appareil.

Du fait de cette liaison de la partie électronique et de l'alimentation logées dans l'appareil avec la moyenne ou haute tension, la réglementation en matière de sécurité prescrit de respecter des lignes de fuite de grande longueur et de réaliser une séparation galvanique de toutes les liaisons partant de l'appareil de mesure et y arrivant.

De telles liaisons électriques, vers et à partir de l'appareil de mesure, sont particulièrement nécessaires et souhaitables lorsque l'on doit effectuer des mesures en continu et que, pour des raisons de capacités, il n'est pas possible de réaliser une alimentation sans interruption à partir de la source de tension incorporée (piles ou batterie) et que, par suite, il est nécessaire de prévoir une alimentation extérieure alimentée par le réseau. Cette nécessité existe également lorsque l'on doit réaliser une transmission de données vers et à partir de l'appareil de mesure en vue de leur exploitation ou pour des fonctions de commande.

Des dispositifs intégrés de couplage à transmission capacitive ou optoélectronique ne présentent pas les caractéristiques d'isolation nécessaires.

Le problème à la base de la présente invention est de concevoir, pour de tels appareils de mesure, une transmission de données et d'énergie qui soit économique et dont l'encombrement soit le plus faible possible.

Ce problème est résolu par le fait que la transmission de données s'effectue par l'intermédiaire de condensateurs de couplage qui sont constitués, chacun, de deux surfaces conductrices implantées sur des faces opposées l'une à l'autre de deux feuilles supports, que la transmission d'énergie s'effectue par l'intermédiaire d'un transformateur qui est constitué de deux moitiés de noyau fixées sur des faces opposées l'une à l'autre des feuilles supports et comportant des enroulements primaires et secondaires, au moins une des feuilles supports étant une feuille isolante résistant aux hautes tensions et les deux feuilles étant collées l'une sur l'autre.

Grâce à l'utilisation de "condensateurs de couplage", on peut maintenir la consommation d'énergie à un niveau faible par comparaison avec une transmission intégrée sous forme discrète de type optoélectronique ou inductif, ce qui est favorable à la durée de vie des piles ou de la batterie dans le cas où la transmission de données doit être alimentée à partir de la source de tension interne.

Du fait de la réalisation sous forme discrète des condensateurs de couplage à partir d'une feuille isolante résistant aux hautes tensions, on peut obtenir les tensions d'isolement requises avec une structure d'encombrement réduit pouvant être intégrée dans un appareil de mesure.

En ce qui concerne la transmission d'énergie, c'est l'utilisation de la transmission de type inductif qui est la plus appropriée, au moins une feuille support isolante assurant, dans ce cas, l'isolation nécessaire entre l'enroulement primaire et l'enroulement secondaire.

Avantageusement, on utilise les mêmes feuilles supports pour la transmission de données et la transmission d'énergie. Cela permet d'obtenir une structure compacte.

Avantageusement, les surfaces conductrices et les moitiés de noyau sont implantées chacune sur une feuille support et celles-ci sont collées l'une sur l'autre. Cela permet, grâce à un montage des moitiés de noyau sur une seule face de la feuille support, de manipuler plus facilement le dispositif pendant sa fabrication. En même temps, les propriétés isolantes des deux feuilles s'ajoutent.

Si on moule le dispositif dans une résine, on peut encore réduire son encombrement car les lignes de fuite qui doivent être réalisées selon les normes de sécurité ne doivent être respectées qu'aux emplacements de contact du corps moulé ainsi obtenu.

Selon une autre caractéristique de l'invention, les moitiés de noyau du transformateur sont constituées de moitiés de noyau en ferrite en forme de coquille comportant chacune deux enroulements.

Selon encore une autre caractéristique de l'invention, la direction de la transmission d'énergie est commandée par un circuit de surveillance.

D'autres caractéristiques de l'invention ressortiront de la description qui suit, faite en se référant aux dessins annexés représentant un exemple de réalisation de l'invention et dans lesquels :
- la figure 1 représente l'implantation de deux feuilles supports présentant, pour l'essentiel, une symétrie spéculaire;
- la figure 2 est une coupe à travers les deux feuilles supports collées l'une sur l'autre; et
- la figure 3 est le schéma électrique d'un circuit de transmission d'énergie et de données.

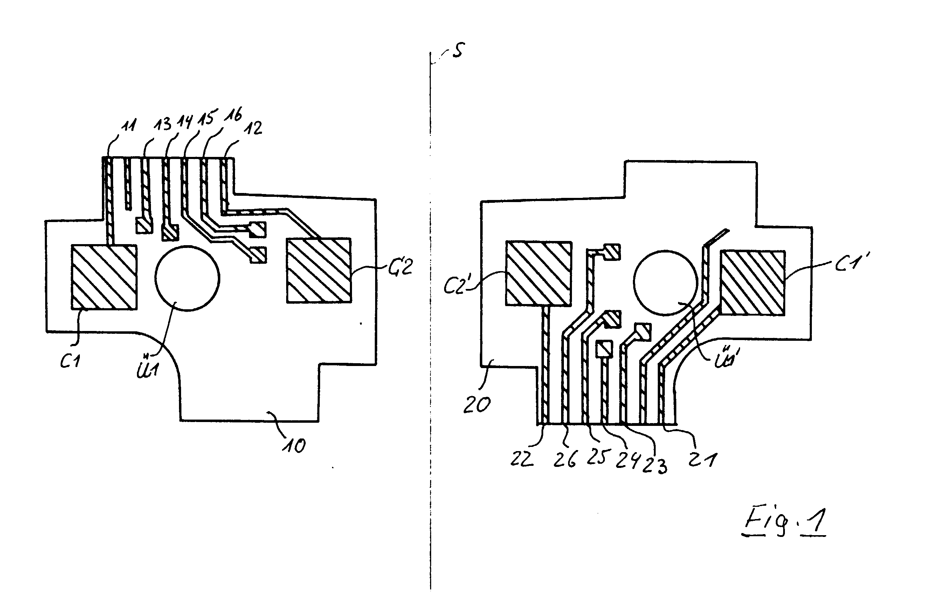

La figure 1 représente l'implantation, vue à partir de la face d'implantation, de deux feuilles supports isolantes 10 et 20 réalisées, pour l'essentiel, du point de vue mécanique, avec une symétrie spéculaire par rapport à un plan S de symétrie.

Sur chacune de ces deux feuilles supports 10 et 20 sont implantées deux surfaces carrées électriquement conductrices en cuivre C1 et C2, respectivement Cl' et C2', qui sont opposées l'une à l'autre lorsque les feuilles supports 10 et 20 sont à l'état monté et qui forment un premier, respectivement un deuxième, condensateur couplé.

L'aire de ces surfaces est déterminée à partir des propriétés connues du matériau support utilisé et de la fréquence inférieure de coupure nécessaire pour la transmission de données en utilisant des étapes de calcul connues de telle manière que, à l'état monté, on obtienne la capacité de couplage souhaitée.

Entre ces surfaces conductrices est collée, sur chaque feuille support, une moitié de noyau Ü1, respectivement Ü1', comportant chacune deux enroulements. Les dimensions du noyau, sa matière et le nombre de spires de ses enroulements sont déterminés en tenant compte de la perméance connue ou mesurée du matériau support utilisé et de la forme et de la fréquence des signaux nécessaires pour la transmission de données en utilisant des étapes de calcul connues.

Pour pouvoir réaliser les surfaces C1, C2, Cl' et C2' ainsi que les moitiés de noyau Ü1 et Ü1' avec les plus faibles dimensions possibles, on utilise des feuilles à pouvoir d'isolement élevé et particulièrement minces.

En outre, pour les enroulements des moitiés de noyau, on prévoit des surfaces de connexion qui, comme pour les surfaces conductrices C1, C2, Cl' et C2', sont adaptées au raccordement à une partie électronique, au moyen de pistes conductrices comportant des surfaces de contact 11 à 16, respectivement 21 à 26. Ces surfaces de contact 11 à 16 et 21 à 26 sont disposées sur des faces opposées des feuilles supports pour assurer des lignes de fuite les plus longues possible entre le côté primaire et le côté secondaire.

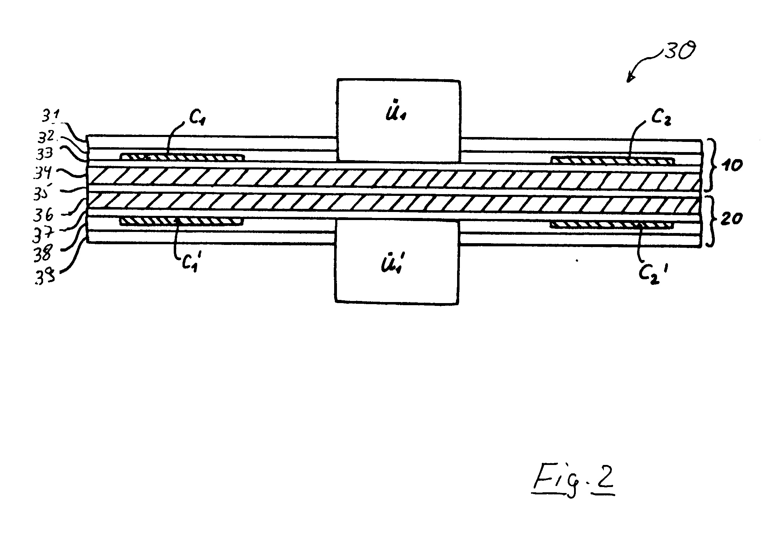

La figure 2 est une vue en coupe à une échelle différente de l'ensemble 30 constitué des deux feuilles supports collées l'une sur l'autre. Les deux feuilles supports feuilles supports 10 et 20 sont collées l'une sur l'autre au moyen d'une feuille de collage 35. Ces deux feuilles supports 10 et 20 sont elles-mêmes constituées chacune d'une structure en "sandwich" identique.

Le sandwich de la feuille support 10 - les feuilles correspondantes de la feuille support 20 sont indiquées entre parenthèses - est constitué d'une feuille de base 34 (36) isolante, résistant aux hautes tensions et sur laquelle est placée une autre feuille de collage 33 (37) au moyen de laquelle les surfaces conductrices C1 et C2 (Cl' et C2'), les pistes conductrices et les surfaces de contact (non représentées) et les moitiés de noyau Ü1 (Ü1') sont collées sur la feuille de base 34 (36). Au moyen d'une autre feuille de collage 32 (38), une feuille de recouvrement 31 (39), prévue en particulier pour la protection des surfaces en cuivre contre la corrosion, est maintenue sur le dessus.

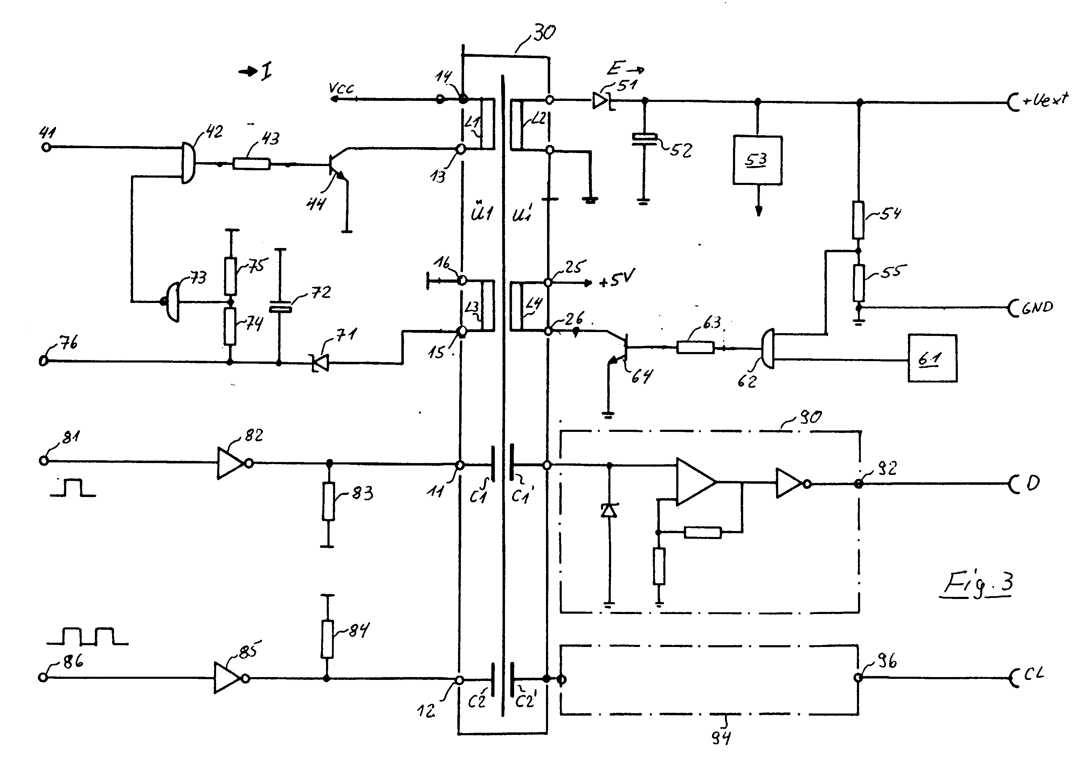

La figure 3 est un schéma électrique simplifié d'un circuit pour la transmission d'énergie et de données dans lequel les signaux internes de l'appareil de mesure sont fournis du côté gauche et les liaisons vers l'extérieur sont dirigées vers la droite.

Pour l'alimentation en énergie de la partie électronique, qui est galvaniquement séparée et disposée du côté externe E, dans le cas où il n'y a pas d'alimentation extérieure mais qu'il faut effectuer une transmission de données à partir de l'appareil de mesure en vue d'une exploitation à l'extérieur, on applique à une première entrée 41 un premier signal d'horloge rectangulaire qui est envoyé sur une première entrée d'un circuit ET 42. Une deuxième entrée de ce circuit ET 42 est reliée à la sortie d'un inverseur 73 qui, comme cela sera décrit par la suite, fournit, dans cet état de fonctionnement, un signal logique de niveau "1".

La sortie du circuit ET 42 est reliée à la borne de base d'un premier transistor d'attaque 44 par l'intermédiaire d'une résistance en série 43. L'émetteur de ce transistor d'attaque 44 est relié à la masse et son collecteur est relié à une première borne de l'enroulement L1 de la moitié de noyau Ü1 par l'intermédiaire de la surface de connexion 13. La deuxième borne de l'enroulement L1 est reliée à la tension de service Vcc.

Le signal ainsi obtenu à partir du premier signal d'horloge est transmis à l'enroulement L2 de la moitié de noyau Ü1' dont une borne est reliée à la masse extérieure GND et l'autre borne est reliée à l'anode d'une diode Schottky 51 en vue d'un redressement. La cathode de cette diode Schottky 51 est reliée à un condensateur de lissage 52, à l'entrée d'un régulateur de tension linéaire 53 ainsi qu'à la borne d'entrée de la source de tension extérieure Uext. La sortie du régulateur de tension linéaire 53 fournit une tension d'alimentation de + 5 V destinée à la partie électronique qui se trouve du côté externe E, ces connexions n'étant pas représentées pour des raisons de clarté.

Un diviseur de tension 54, 55, qui est disposé entre la borne d'entrée prévue pour la tension d'alimentation extérieure + Eext et la masse externe GND et dont la prise médiane est reliée à une première entrée d'un circuit ET 62, est réglé de telle sorte que, dans cet état de fonctionnement, la valeur de la tension à la première entrée du circuit ET 62 est égale à un "0" logique. De cette manière, un signal d'horloge rectangulaire, provenant d'un générateur de signaux d'horloge 61 et présent sur la deuxième entrée du circuit ET 62, ne peut parvenir à la sortie de ce dernier.

S'il y a une tension plus élevée en tant que tension extérieure d'alimentation + Eext, la valeur de la tension à la première entrée du circuit ET 62 est égale à un "1" logique et le signal d'horloge présent sur sa deuxième sortie est transmis à sa sortie.

Un circuit travaillant en sens inverse est constitué d'une résistance série 63 reliée à la sortie du circuit ET 62 et à la borne de base d'un deuxième transistor d'attaque 64 dont l'émetteur est relié à la masse externe GND et dont le collecteur est relié à une première borne de l'enroulement L4 de la moitié de noyau Ü1' par l'intermédiaire de la surface de connexion 26. La deuxième borne de cet enroulement L4 est reliée à la tension de service de + 5 V.

Le signal ainsi produit est transmis à l'enroulement L3 de la moitié de noyau Ü1 dont une borne est reliée à la masse et l'autre borne est reliée à l'anode d'une diode Schottky 71 en vue d'un redressement. La cathode de cette diode Schottky 71 est reliée à un condensateur de lissage 72, à une sortie 76, qui conduit à la tension d'alimentation interne, et à un diviseur de tension 74, 75 dont la prise médiane est reliée à l'entrée de l'inverseur 73.

La tension existant dans cet état de fonctionnement est évaluée par l'inverseur 73 comme étant un signal logique "1" afin que sa sortie prenne la valeur logique "0" et bloque le circuit ET 42.

La transmission de données est indiquée, dans l'exemple représenté, seulement pour une direction, mais, selon une modification du dispositif, elle peut s'effectuer dans les deux directions.

Dans le présent exemple, on effectue une transmission de données et de l'horloge de données en vue de la synchronisation. A cet effet, les données parviennent, par l'intermédiaire d'une entrée 81, à un premier circuit intégré inverseur d'attaque 82 dont la sortie est reliée à une résistance de charge 83 et, par l'intermédiaire de la surface de connexion 11, à la surface conductrice C1.

Au moyen du couplage capacitif avec la surface conductrice Cl', des signaux impulsionnels correspondants parviennent à un premier circuit de mise en forme 90 qui, de manière connue, transforme ces derniers en des signaux rectangulaires et fournit une sortie de données D par l'intermédiaire d'une sortie 92.

On procède de manière correspondante pour le signal d'horloge de données qui parvient, par l'intermédiaire d'une entrée 86, à un premier circuit intégré inverseur d'attaque 85 dont la sortie est reliée à une résistance de charge 84 et, par l'intermédiaire de la surface de connexion 12, à la surface conductrice C2.

Au moyen du couplage capacitif avec la surface conductrice C2', des signaux impulsionnels correspondants parviennent à un premier circuit de mise en forme 94 qui, de manière connue, transforme ces derniers en des signaux rectangulaires et fournit une sortie d'horloge Cl par l'intermédiaire d'une sortie 96.

## Revendications

1. Dispositif de transmission séparée de données et d'énergie pour appareil de mesure portatif, tel qu'un multimètre à pince ampèremétrique, caractérisé en ce que la transmission de données s'effectue par l'intermédiaire de condensateurs de couplage qui sont constitués, chacun, de deux surfaces conductrices (C1, Cl'; C2, C2') implantées sur des faces opposées l'une à l'autre de deux feuilles supports (10, 20), en ce que la transmission d'énergie s'effectue par l'intermédiaire d'un transformateur qui est constitué de deux moitiés de noyau (Ü1, Ü2) fixées sur des faces opposées l'une à l'autre des feuilles supports (10, 20) et comportant des enroulements primaires et secondaires (L1 à L4), en ce qu'au moins une des feuilles supports (10, 20) est une feuille isolante résistant aux hautes tensions, et en ce que les deux feuilles sont collées l'une sur l'autre.

2. Dispositif de transmission selon la revendication 1, caractérisé en ce qu'il est moulé dans une résine isolante.

3. Dispositif de transmission selon la revendication 1, caractérisé en ce que les moitiés de noyau (Ü1, Ü2) du transformateur sont constituées de moitiés de noyau en ferrite en forme de coquille comportant chacune deux enroulements (L1, L2; L3, L4).

4. Dispositif de transmission selon la revendication 3, caractérisé en ce que la direction de la transmission d'énergie est commandée par un circuit de surveillance.
